Europäisches Patentamt

European Patent Office

Office européen des brevets

(19)

(11) Veröffentlichungsnummer. **0 018 573**
**B1**

(12) **EUROPÄISCHE PATENTSCHRIFT**

(45) Veröffentlichungstag der Patentschrift:
**19.09.84**

(21) Anmeldenummer: **80102143.7**

(22) Anmeldetag: **21.04.80**

(51) Int. Cl.³: **H 03 K 17/96**

(54) Monolithisch integrierte digitale MOS-Halbleiterschaltung.

(30) Priorität: **30.04.79 DE 2917596**

(43) Veröffentlichungstag der Anmeldung:
**12.11.80 Patentblatt 80/23**

(45) Bekanntmachung des Hinweises auf die Patenterteilung:
**19.09.84 Patentblatt 84/38**

(84) Benannte Vertragsstaaten:
**FR GB**

(56) Entgegenhaltungen:
**DE - A - 2 713 319**
**GB - A - 1 451 445**
**US - A - 4 124 807**

**TOUTE L'ELECTRONIQUE, Nr. 441, März 1979, Seite 95
Paris, FR. CHATAIGNIER: "Commande à effleurement"**

(73) Patentinhaber: **Siemens Aktiengesellschaft, Berlin und
München Wittelsbacherplatz 2, D-8000 München 2 (DE)**

(72) Erfinder: **Rösler, Helmut, Ottobrunnerstrasse 101,
D-8000 München 83 (DE)**
Erfinder: **Irmer, Helmbert Ulrich, Dipl.-Ing., Lehmstich 29,
D-4390 Gladbeck (DE)**
Erfinder: **Bigall, Klaus-Dieter, Dipl.-Phys., Irisstrasse 28,
D-8011 Vaterstetten (DE)**

## Beschreibung

Die vorliegende Erfindung betrifft eine monolithisch integrierte digitale MOS-Halbleiterschaltung mit einem als Signaleingang dienenden elektrischen Anschluß an der Oberfläche des die Halbleiterschaltung aufnehmenden Halbleiterkörpers, bei der dieser Anschluß durch einen manuell zu bedienenden Sensorschalter mit einem aufgrund dieser Betätigung entstehenden und an die digitale Halbleiterschaltung weiterzuleitenden Sensorsignal zu beaufschlagen ist und aufgrund dieser Beaufschlagung in der digitalen Halbleiterschaltung ein Antwortsignal entsteht, welches unter Vermittlung des besagten elektrischen Anschlusses zur Beaufschlagung eines externen Indikators vorgesehen ist, bei der zur Erzeugung des Antwortsignals eine auf das Sensorsignal ansprechende Schaltung im Halbleiterkörper vorgesehen und derart ausgestaltet ist, daß der elektrische Anschluß über einen getakteten Schaltungsteil an eine Flip-Flopzelle gelegt ist, bei der außerdem zwecks Erzeugung des Sensorsignals die dem elektrischen Anschluß des Halbleiterkörpers abgewandte Seite des Sensorschalters an ein Versorgungspotential $V_{GG}$ angeschlossen ist, welches zusammen mit einem Bezugspotential $V_{ss}$ auch zur Versorgung der integrierten Halbleiterschaltung vorgesehen ist.

Eine solche MOS-Halbleiterschaltung ist in der britischen Patentschrift 1 451 445 beschrieben.

Ebenso wie diese Patentschrift befaßt sich die Erfindung mit der Aufgabe, eine Schaltung anzugeben, bei der das an den Signaleingang zu legende elektrische Signal mittels eines Sensorschalters erzeugt wird. Ein solcher Sensorschalter besteht bekanntlich aus einer durch eines der Versorgungspotentiale der Halbleiterschaltung beaufschlagten ersten Elektrode und einer mit dem elektrischen Anschluß des Halbleiterkörpers verbundenen zweiten Elektrode, wobei die freie Strecke zwischen den beiden Elektroden des Sensorschalters durch einen Widerstand zu überbrücken ist, der durch den Finger der den Sensorschalter betätigenden Person gegeben ist. Demzufolge liegt an dem elektrischen Anschluß des Halbleiterkörpers nur solange ein externes Signal, als der Sensorschalter durch den Finger der bedienenden Person überbrückt ist.

Erwünscht ist nun, daß der Empfang des über den Sensorschalter erzeugten Signals durch die digitale Halbleiterschaltung mittels eines entsprechenden Antwortsignals, z. B. über eine Leuchtdiode, angezeigt wird. Hierzu ist im Interesse der Einsparung von äußeren Anschlüssen (Pins) wünschenswert, wenn das Antwortsignal ebenfalls über den genannten Anschluß des Halbleiterkörpers zu der im allgemeinen nicht mit der digitalen Halbleiterschaltung monolithisch integrierbaren Anzeigevorrichtung zu leiten, und wenn über denselben Anschluß das Zurückschalten der digitalen Halbleiterschaltung möglich ist. Schließlich ist ein möglichst störungsfreies Arbeiten der Schaltung erwünscht. Es ist Aufgabe der vorliegenden Erfindung, hierzu eine geeignete Möglichkeit anzugeben.

Gemäß der vorliegenden Erfindung ist hierzu vorgesehen, daß der elektrische Anschluß des Halbleiterkörpers über die Source-Drainstrecke eines ersten MOS-Feldeffekttransistors und über eine hierzu parallel geschaltete Kapazität an das den logischen Pegel »0« bedeutende Bezugspotential gelegt und für die Steuerung des Gates des ersten Feldeffekttransistors eine erste Folge periodischer Taktimpulse vorgesehen ist, daß durch die erste Folge periodischer Taktimpulse die in der Kapazität gespeicherte Ladung abgebaut wird und der elektrische Anschluß auf das dem logischen Pegel »0« entsprechende Bezugspotential gezogen wird, so daß nach jeder Beaufschlagung über den Sensorschalter der elektrische Anschluß auf die nächste Beaufschlagung vorbereitet wird, daß bei der nächsten Betätigung des Sensorschalters das Versorgungspotential an den elektrischen Anschluß gelegt und damit eine Aufladung der Kapazität eingeleitet wird, daß außerdem der elektrische Anschluß zur Steuerung eines im übrigen noch von den Impulsen einer zweiten Taktfolge beaufschlagten Schaltungsteils mit UND-Funktion an den Informationseingang einer getakteten Schieberegisterzelle angeschaltet ist, deren Ausgang zur Beaufschlagung der — bereits der eigentlichen digitalen Halbleiterschaltung angehörenden — Flip-Flopzelle dient, daß ferner der elektrische Anschluß über einen aus einem Feldeffekttransistor bestehenden Schaltungsteil mit dem dem logischen Pegel »1« entsprechenden Versorgungspotential beaufschlagt und hierzu dieser Schaltungsteil sowohl durch einen Ausgang der Flip-Flopzelle als auch durch eine weitere Folge von Taktimpulsen gesteuert ist, und daß schließlich die in einer gemeinsamen Anlage erzeugten drei Folgen von Taktimpulsen derart aufeinander abgestimmt sind, daß kein Impuls mit einem Impuls einer anderen dieser Taktfolgen gleichzeitig erscheint und daß unmittelbar vor jedem Impuls der zuletzt genannten Taktfolge ein Impuls der zweiten Taktfolge und unmittelbar vor dem Impuls der zweiten Taktfolge ein Impuls der ersten Taktfolge erscheint, wobei jede erneute Betätigung des Sensorschalters den Zustand der Flip-Flopzelle in den logisch entgegengesetzten Zustand bringt und ein dem Zustand der Flip-Flopzelle entsprechender und mit dem Impuls der zuletzt genannten Taktfolge getaktetes Antwortsignal an den elektrischen Anschluß gibt.

Neben den soeben genannten Maßnahmen kann folgende weitere Ausgestaltung der Erfindung zweckmäßig sein:

a)  Die Impulserzeugungsanlage ist durch einen oszillatorgesteuerten Binärzähler gegeben, der über einen Dekoder die einzelnen Impulsfolgen an die jeweils erforderliche Stelle weitergibt.

b) Durch eine Schieberegisterzelle bzw. durch den weiteren Schaltungsteil mit UND-Funktion wird eine Flip-Flopzelle aktiviert, welche einmal für die weitere Steuerung der eigentlichen digitalen Halbleiterschaltung und zum anderen für die Erzeugung eines auf den genannten Anschluß des Halbleiterkörpers zu gebenden Antwortsignals dient, welches als Bestätigung des Eingangs des Sensorsignals bei der eigentlichen integrierten digitalen Halbleiterschaltung verwendet werden kann.

c) Die in der Schaltung verwendeten MOS-Feldeffekttransistoren sind bevorzugt vom Anreicherungstyp und entweder in n-Kanaltechnik oder in p-Kanaltechnik in Übereinstimmung mit der bei der Herstellung der eigentlichen integrierten digitalen MOS-Schaltung verwendeten Technologie erzeugt.

Die durch die GB-PS 1 451 445 bekannte Schaltung entsprechend der eingangs gegebenen Definition ist derart ausgestaltet, daß der elektrische Anschluß des Halbleiterkörpers für das Sensorsignal, über den auch das Antwortsignal geführt wird, jederzeit für die beiden Betriebsarten zur Verfügung steht, so daß auch während des Auftretens des Antwortsignals externe Störsignale an den Anschluß gelangen können. Dies kann eine Beeinträchtigung des Antwortsignals zur Folge haben.

Im Gegensatz zu der bekannten Schaltung arbeitet die erfindungsgemäße Schaltung im Multiplexbetrieb, so daß normalerweise zwar der Anschluß des Halbleiterkörpers für das Sensorsignal zur Verfügung steht, daß aber dann die Zufuhr weiterer über den Anschluß in das Innere der digitalen Halbleiterschaltung gelangender Signale solange gesperrt ist, wenn der Anschluß mit dem Sensorsignal beaufschlagt und das Antwortsignal noch nicht an den Anschluß gelangt ist. Zu erwähnen ist noch, daß sich die erfindungsgemäße Schaltung auch ausschließlich mit MOS-Kondensatoren realisieren läßt, da ggf. die in der Schaltung auftretenden Kondensatoren parasitärer Natur sein können.

Die Erfindung wird nun anhand der Fig. 1 bis 3 näher beschrieben.

Fig. 1 stellt eine bevorzugte Ausgestaltung der Erfindung im Schaltbild dar, bei der als der weitere Schaltungsteil mit UND-Funktion ein zweiter, als Transfertransistor geschalteter MOS-Feldeffekttransistor verwendet und außerdem der Eingang der eigentlichen Digitalschaltung durch eine quasistatische Schieberegisterzelle gegeben ist.

Fig. 2 zeigt das Schaltbild einer statischen Schieberegisterzelle als Ersatz für die bei der Schaltung gemäß Fig. 1 verwendete quasistatische Registerzelle. In

Fig. 3 schließlich ist die zeitliche Zuordnung der den ersten MOS-Feldeffekttransistor und der den zweiten MOS-Feldeffekttransistor steuernden Impulse zueinander und in bezug auf das von der Schaltung gelieferte Antwortsignal dargestellt.

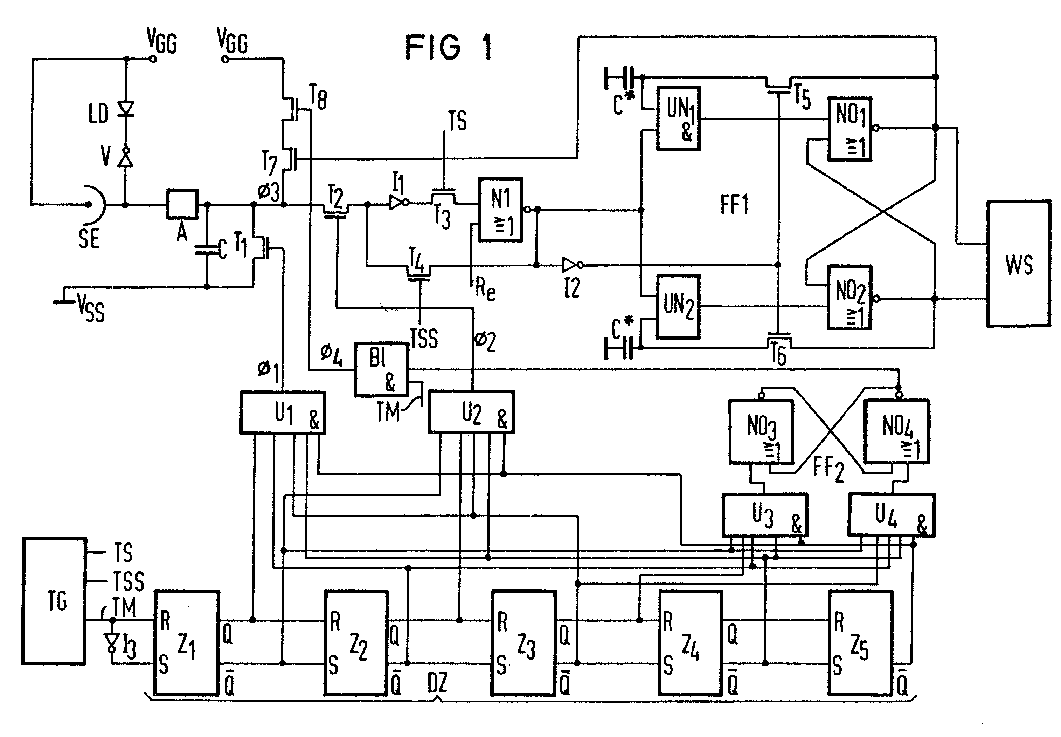

Bei der in Fig. 1 dargestellten Anlage gemäß der Erfindung wird mittels eines Sensorschalters SE das eine der beiden für den Betrieb der Gesamtanlage vorgesehenen Betriebspotentiale, nämlich das Potential $V_{GG}$, unter Vermittlung des Körpers der die Schaltung betätigenden Person als Überbrückungswiderstand an den Anschluß A des die digitale Halbleiterschaltung enthaltenden Halbleiterkristalls, insbesondere Siliciumkristalls, gelegt und auf diese Weise ein an die digitale Halbleiterschaltung gerichtetes Signal erzeugt. Gegenüber dem zweiten — über Masse an die Schaltung gelegten — Betriebspotential $V_{SS}$, also dem Bezugspotential, ist in der Regel eine Kapazität des Anschlusses A gegeben, die durch den Kondensator C angedeutet ist. Der Kondensator C kann schaltungsmäßig durch einen MOS-Kondensator oder auch nur auf rein parasitärer Grundlage gegeben sein.

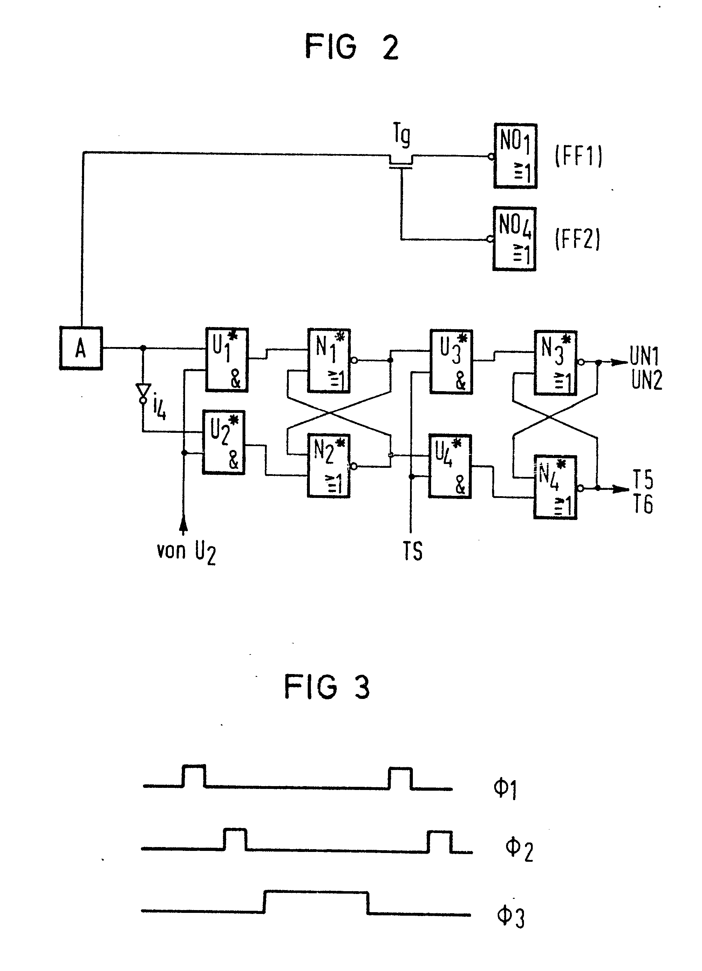

Die Kapazität C ist durch die Source-Drainstrecke eines ersten MOS-Feldeffekttransistors $T_1$ überbrückt, dessen Gate durch die aus dem ersten Diagramm von Fig. 3 ersichtliche Impulsfolge $\Phi_1$ gesteuert ist. Der Anschluß A ist ferner mit der Source eines zweiten MOS-Feldeffekttransistors $T_2$ verbunden, der den Weg vom Anschluß A in die digitale Halbleiterschaltung und damit den Weg für das vom Sensorschalter SE gelieferte Signal bildet.

Bei dem in Fig. 1 dargestellten Ausführungsbeispiel ist der zweite MOS-Feldeffekttransistor $T_2$ der Eingangs-Transfertransistor $T_2$ einer quasistatischen Schieberegisterzelle, deren Ausgang zur Steuerung eines Toggle-Flip-Flops $FF_1$ und über dieses zur Steuerung der weiteren Bestandteile WS der digitalen Halbleiterschaltung vorgesehen ist. Der zweite MOS-Feldeffekttransistor $T_2$ wird über sein Gate mit der aus dem zweiten Diagramm von Fig. 3 ersichtlichen Impulsfolge $\Phi_2$ gesteuert.

Um eine quasistatische Schieberegisterzelle zu bilden, ist der Drain des zweiten MOS-Transistors $T_2$ über einen Inverter $I_1$ und einen über sein Gate von einer Taktfolge TS gesteuerten dritten und als Transfertransistor geschalteten MOS-Feldeffekttransistor $T_3$ an den einen Eingang eines NOR-Gatters $N_1$ gelegt. Der andere Eingang dieses NOR-Gatters $N_1$ ist durch ein Resetsignal Re zu steuern. Außerdem ist der Drain des zweiten MOS-Feldeffekttransistors $T_2$ über einen über sein Gate durch eine Impulsfolge $T_{SS}$ gesteuerten vierten MOS-Feldeffekttransistor $T_4$ mit dem Ausgang des besagten NOR-Gatters $N_1$ und damit mit dem Signalausgang der quasistatischen Schieberegisterzelle verbunden.

Die Flip-Flopzelle $FF_1$ besteht aus einem Masterteil und einem Slaveteil, die im wesentlichen durch die beiden UND-Gatter $UN_1$ und $UN_2$ bzw. durch die beiden weiteren NOR-Gatter $NO_1$ und $NO_2$ gegeben sind. Zur Steuerung des Masterteils ist je einer der beiden Eingänge jedes der beiden UND-Gatter $UN_1$ und $UN_2$ unmittelbar an

den Ausgang des NOR-Gatters $N_1$ und damit an den Ausgang der quasistatischen Schieberegisterzelle gelegt. Die Steuerung des Slaveteils von $FF_1$ ist gegeben, indem die Ausgänge der beiden UND-Gatter $UN_1$ und $UN_2$ des Masterteils jeweils an einen der beiden Eingänge des durch die beiden kreuzgekoppelten NOR-Gatter $NO_1$ und $NO_2$ gegebenen Slaveteils gelegt sind. Die beiden Ausgänge der infolge der Kreuzkopplung ein Basis-Flip-Flop (NOR-Latch) bildenden NOR-Gatter $NO_1$ und $NO_2$ bilden je einen Signalausgang der Toggle-Flip-Flopzelle $FF_1$, die zur Schaltung und Steuerung weiterer Bestandteile WS der eigentlichen und nach den jeweils vorliegenden Gesichtspunkten auszugestaltenden digitalen Halbleiterschaltung vorgesehen sind. Außerdem ist je einer der beiden Ausgänge des Flip-Flops $FF_1$ über die Source-Drainstrecke je eines weiteren MOS-Feldeffekttransistors $T_5$ bzw. $T_6$ auf den anderen Eingang je eines der beiden UND-Gatter $UN_1$ und $UN_2$ im Masterteil zurückgeschaltet. Die Gates der beiden Transistoren $T_5$ und $T_6$ werden vom Ausgang der quasistatischen Schieberegisterzelle, also dem Ausgang des NOR-Gatters $N_1$, unter Zwischenfügung eines Inverters $I_2$ gesteuert.

Innerhalb des die digitale Halbleiterschaltung aufnehmenden Halbleiterkristalls ist ferner die Serienschaltung zweier weiterer MOS-Feldeffekttransistoren $T_7$ und $T_8$ vorgesehen, mit deren Hilfe der elektrische Anschluß A des Halbleiterkristalls an ein vom Massepotential $V_{SS}$ verschiedenes Betriebspotential, insbesondere an das zur Beaufschlagung des Sensorschalters SE dienende Potential $V_{GG}$ anschaltbar ist. Hierzu ist der näher am Anschluß A liegende Transistor $T_7$ über sein Gate von dem nicht invertierenden Ausgang des Toggle-Flip-Flops $FF_1$ gesteuert, während das Gate des Transistors $T_8$ durch den invertierenden Ausgang eines RS-Flip-Flops $FF_2$ beaufschlagt ist.

Als Taktgenerator TG ist eine Anlage zu verwenden, welche sowohl einen Takt TM, als auch einen Takt TS und einen Takt TSS abgibt. Eine solche Anlage ist z. B. in der DE-Patentanmeldung P 2 845 379.4 (VPA 78 P 1191) beschrieben. Diese Anlage ist dazu befähigt, drei unter Phasenverschiebung ablaufende periodische Taktimpulsfolgen TM, TS und TSS abzugeben. Die Taktfolge TM besteht aus zeitlich äquidistanten Rechteckimpulsen mit dem Pegel logisch »1«. Dasselbe gilt für die Taktfolge TS, die dieselbe Frequenz wie die Folge TM hat. Jedoch sind die Impulse der Folge TM so gegen die Impulse der Folge TS phasenverschoben, daß die Impulse TS nur dann den Zustand »1« haben, wenn die Folge TM den Zustand »0« hat. Außerdem ist zwischen den Flanken der Einzelimpulse von TM und den jeweils zeitlich benachbarten Einzelimpulsen von TS jeweils eine nicht verschwindende Zeitdifferenz gegeben. Die Einzelimpulse der Folge TSS fallen zeitlich mit den Einzelimpulsen der Folge TS zusammen, was exakt für die Übergänge von logisch »1« auf logisch »0« gilt. Hingegen haben die Einzelimpulse der Folge TSS im Gegensatz zu den Impulsen TS merklich schräg ansteigende Übergänge von logisch »0« auf logisch »1« und dementsprechend eine im Vergleich zu den Impulsen TS merklich verkürzte Dauer des Pegels logisch »1«.

Die Taktfolge TS eines solchen — insbesondere für die Taktversorgung von quasistatischen Schieberegistern geeigneten — Taktgenerators wird bei einer der Erfindung entsprechenden Halbleiterschaltung gemäß Fig. 1 für die Steuerung des vierten MOS-Feldeffekttransistors $T_4$ und damit des unmittelbaren Weges vom Drain des zweiten MOS-Transistors $T_2$ und dem Ausgang des NOR-Gatters $N_1$ verwendet. Der Takt TS dient zur Steuerung des dritten MOS-Feldeffekttransistors $T_3$ und damit des einen Eingangs des NOR-Gatters $N_1$. Hingegen wird der Takt TM zur Beaufschlagung eines Dualzählers DZ verwendet.

Dieser Dualzähler DZ ist durch eine Kette hintereinander geschalteter Flip-Flopzellen $Z_1$—$Z_5$ gegeben, die jeweils einen nicht invertiert und einen invertiert zu steuernden Eingang, also zwei Eingänge R und S sowie zwei entsprechende Ausgänge Q und $\bar{Q}$ aufweisen. Dabei sind die beiden Ausgänge Q und $\bar{Q}$ der jeweils in der Kette vorgeschalteten Zählstufe $Z_i$ mit je einem der beiden Eingänge der jeweils nachgeschalteten Zählstufe $Z_{i+1}$ verbunden.

Die einzelnen Zählstufen $Z_i$ sind z. B. entsprechend der Flip-Flopzelle $FF_1$ ausgestaltet. Die zu zählenden Impulse, z. B. die Impulse TM, gehen unmittelbar auf den einen Eingang und über einen Inverter $I_3$ an den anderen Eingang der ersten Zählstufe $Z_1$ des Dualzählers DZ. Die Ausgänge Q und $\bar{Q}$ der einzelnen Zählstufen $Z_i$ vermitteln unter Berücksichtigung der Reihenfolge i der Zellen $Z_i$ den jeweils erreichten Zählstand des Dualzählers DZ. Diese Ausgänge dienen zur Beaufschlagung einer Dekodierschaltung, mit deren Hilfe die zur Steuerung der beiden MOS-Feldeffekttransistoren $T_1$ und $T_2$ erforderlichen Impulsfolgen $\varPhi_1$ und $\varPhi_2$ sowie die zur Steuerung des bereits erwähnten RS-Flip-Flops $FF_2$ erforderlichen Impulse gewonnen werden.

Im Beispielsfall hat der Dualzähler DZ fünf Zählstufen $Z_1$—$Z_5$ und ist deshalb für die Auszählung bis zu $2^6$ Zählimpulsen ausreichend, bevor eine Rücksetzung in den Ausgangszustand erfolgt. Im allgemeinen Fall hat der Dualzähler n Zählstufen $Z_1$—$Z_n$.

Gemäß Fig. 1 weist der Dekoder ein erstes UND-Gatter $U_1$ mit fünf Eingängen auf, das mit seinem Ausgang an das Gate des ersten MOS-Feldeffekttransistors $T_1$ gelegt und mit seinen Eingängen mit je einem der invertierten Ausgänge $\bar{Q}$ der vorgesehenen fünf Zählstufen $Z_1$—$Z_5$ verbunden ist. Im allgemeinen Fall hat das erste UND-Gatter $U_1$ n Signaleingänge entsprechend der Anzahl n der Zählstufen des Dualzählers DZ, wobei die $\bar{Q}$-Ausgänge der Zählstufen von DZ jeweils mit je einem Eingang des UND-Gatters $U_1$ verbunden sind.

Ein zweites zur Steuerung des vom Anschluß A des Halbleiterkörpers in die quasistatische Schieberegisterzelle und damit in die digitale Halbleiterschaltung führenden MOS-Transistors $T_2$ dienendes UND-Gatter $U_2$ weist in dem in Fig. 1 dargestellten Beispielsfall fünf Eingänge auf. Diese liegen — mit Ausnahme eines Eingangs — an den $\overline{Q}$-Ausgängen und der als Ausnahme genannte Eingang an einem Q-Ausgang, und war im Beispielsfall derart, daß der $\overline{Q}$-Ausgang der ersten, der dritten, der vierten und der fünften Zählstufe und der Q-Ausgang der zweiten Zählstufe $Z_2$ an je einem Eingang des zweiten UND-Gatters $U_2$ liegen. Im allgemeinen Fall bei n Zählstufen $Z_i$ hat auch das zweite UND-Gatter n Eingänge, wobei sich auch hier empfiehlt, wenn der nicht invertierende Ausgang Q der zweiten Zelle $Z_2$ und die invertierenden Ausgänge $\overline{Q}$ der übrigen Zellen $Z_i$ des Dualzählers DZ an je einem Eingang des zweiten UND-Gatters $U_2$ liegen.

Der Ausgang des ersten dieser UND-Gatter, also das UND-Gatter $U_1$ liefert die Impulse $\Phi_1$, der Ausgang des UND-Gatters $U_2$ liefert die Impulse $\Phi_2$. Die beschriebene Anschaltung hat den Vorteil, daß die Impulse $\Phi_1$ und $\Phi_2$ mit gleicher Frequenz erscheinen.

Zwei weitere UND-Gatter $U_3$ und $U_4$ dienen dazu, um das RS-Flip-Flop $FF_2$ zu setzen. Im Beispielsfalle gemäß Fig. 1 haben diese beiden UND-Gatter ebenfalls 5 Eingänge. Dabei ist ein Eingang des UND-Gatters $U_3$ mit dem Q-Ausgang der dritten Zählstufe $Z_3$ und ein Eingang des vierten UND-Gatters $U_4$ mit dem Q-Ausgang der vierten Zählstufe $Z_4$ verbunden, während die Beaufschlagung der übrigen Eingänge des UND-Gatters $U_3$ durch den $\overline{Q}$-Ausgang je einer der Zählstufen $Z_1$, $Z_2$, $Z_4$ und $Z_5$ und die Beaufschlagung der übrigen Eingänge des UND-Gatters $U_4$ durch den $\overline{Q}$-Ausgang je einer der Zählstufen $Z_1$, $Z_2$, $Z_3$ und $Z_5$ gegeben ist.

Es wird also ein bestimmter Zählstand auskodiert, um das RS-Flip-Flop in den einen Zustand und ein zweiter Zählstand ausgewählt, um das RS-Flip-Flop $FF_2$ wieder in den Ausgangszustand zu schalten. Dasselbe gilt auch für den allgemeinen Fall der Verwendung eines Dualzählers DZ mit n Zählstufen.

Das RS-Flip-Flop $FF_2$ ist durch die beiden kreuzgekoppelten NOR-Gatter $NO_3$ und $NO_4$ gegeben, wobei der noch freie Eingang des NOR-Gatters $NO_3$ vom UND-Gatter $U_3$ und der noch freie Eingang des NOR-Gatters $NO_4$ vom Ausgang des UND-Gatters $U_4$ gesteuert ist. Der Ausgang des NOR-Gatters $NO_4$ ist mit dem Gate des Transistors $T_8$ verbunden.

Es kann im Interesse der Vermeidung von Störungen zweckmäßig sein, wenn jedes der den Dekoder bildenden UND-Gatter $U_1$, $U_2$, $U_3$ und $U_4$ jeweils mit einem zusätzlichen Eingang versehen ist, der dann unmittelbar durch die am Zähleingang anstehenden Zählimpulse, also z. B. durch die Impulse TM beaufschlagt ist.

Die in Fig. 1 angegebenen Kapazitäten C* sind zwar im allgemeinen parasitärer Natur. Schaltungsmäßig bilden sie jedoch eine Ergänzung des Toggle-Flip-Flops $FF_1$, mit deren Hilfe

der nicht durch das NOR-Gatter $N_1$ sondern von den Ausgängen von $FF_1$ gesteuerte Eingang der beiden UND-Gatter $UN_1$ und $UN_2$ des Masterteils von $FF_1$ an das Bezugspotential $V_{SS}$ gezogen ist.

Der Sensorschalter SE bildet einen die Schaltung ergänzenden Bestandteil, der aufgrund seiner Beschaffenheit sich nicht mit den übrigen Teilen der Schaltung monolithisch zusammenfassen läßt. Weitere externe Schaltungsteile sind durch die auf das über die Transistoren $T_7$ und $T_8$ an den Anschluß A gelegten Antwortsignale zu aktivierende Anzeige gegeben.

Diese Anzeige kann z. B. durch eine Leuchtdiode LD mit vorgeschaltetem Verstärker V gegeben sein, die außerhalb des Halbleiterkörpers angeordnet mit der integrierten Halbleiterschaltung — ebenso wie der Sensorschalter SE — eine bauliche Einheit bildet. Der als Inverter ausgebildete Verstärker V wird von den beiden Betriebspotentialen $V_{GG}$ und $V_{SS}$ versorgt und ist mit seinem Eingang an den Anschluß A und mit seinem Ausgang an die Kathode der Leuchtdiode LD gelegt, deren Anode am Potential $V_{GG}$ liegt.

Die nun vollständig beschriebene Schaltung gemäß Fig. 1 arbeitet wie folgt:

Bei Betätigung des Sensorschalters SE wird über den Sensorschalter SE betätigenden Menschen das Potential $V_{GG}$ an den Anschluß A des Halbleiterkörpers gelegt, wodurch eine Aufladung der Kapazität C eingeleitet und bewirkt wird. Sobald der Transfertransistor $T_2$ von dem UND-Gatter $U_2$ durch das Signal $\Phi_2$ aktiviert ist, wird das Potential $V_{GG}$, also das Potential einer logischen »1« über den Inverter $I_1$ in eine parasitäre Kapazität eingeschrieben, die durch den Transistor $T_3$ gegeben ist.

Mit dem Auftreten des nächsten auf die Aktivierung des UND-Gatters $U_2$ im Dekoder folgenden Zählimpuls TM wird der Transfertransistor $T_2$ wieder blockiert und damit sperrend. Mit dem nächstfolgenden Impuls der Taktfolge TS wird der Transistor $T_3$ leitend und die vom Sensorschalter SE gelieferte logische »1« an das NOR-Gatter $N_1$ weitergegeben, an dessen Ausgang die Information als eine logische »1« erscheint. Hierdurch wird über den Inverter $I_2$ die durch die beiden Transistoren $T_5$ und $T_6$ zwischen dem Ausgang des Slaves und dem Eingang des Masters von $FF_1$ vorgesehene Verbindung zugemacht und das Potential der »1« an den Masterteil von $FF_1$ gelegt.

Dadurch wird die über den Sensorschalter SE erzeugte Information an die weitere Schaltungsteile WS der digitalen Halbleiterschaltung weitergegeben, so daß dort die beabsichtigte Steuerwirkung stattfinden kann.

Infolge der Aktivierung des Masterteils in $FF_1$ kippt dieses Flip-Flop $FF_1$ in den anderen Betriebszustand, wodurch nicht nur die Schaltungsteile WS gesteuert werden, sondern auch der Transistor $T_7$ durchgesteuert wird. Infolge des weiteren Fortschreitens des Zählvorganges im Dualzähler DZ wird schließlich über das UND-Gatter $U_3$ das RS-Flip-Flop $FF_2$ zum Kippen ge-

bracht, wodurch der Transistor $T_8$ leitend wird. Damit wird über die beiden Transistoren $T_7$ und $T_8$ das Potential $V_{GG}$ an den Anschluß A gelegt und damit das im dritten Diagramm von Fig. 3 dargestellte Antwortsignal $\Phi_3$ gegeben. Durch weitere auf den Zähleingang des Zählers DZ gelangende Zählimpulse wird schließlich unter Vermittlung des UND-Gatters $U_4$ das Flip-Flop $FF_2$ zurückgekippt und der Anschluß A vom Potential $V_{GG}$ wieder gelöst. Nun beginnt der Dualzähler DZ eine neue Zählperiode, wodurch dem Transistor $T_1$ die Gelegenheit gegeben wird, die in der Kapazität C gespeicherte Ladung abzubauen und den Anschluß A auf das Bezugspotential, also Masse, und damit auf das Potential der logischen »0« zu ziehen.

Das in Fig. 3, letztes Diagramm dargestellte und durch Öffnen der beiden Transistoren $T_7$ und $T_8$ erzeugte Antwortsignal $\Phi_3$ dient zur Aktivierung der Anzeige. Da am Eingang des Verstärkers V dann das Potential »1« und damit am Ausgang des Verstärkers das Potential »0« gegeben ist liegt zwischen Anode und Kathode der Leuchtdiode LD die volle Potentialdifferenz von $V_{GG}$ und $V_{SS}$, so daß die Diode LD anspricht. Das in Fig. 1 dargestellte und zwischen dem Ausgang des NOR-Gatters $NO_4$ und dem Gate des Transistors $T_8$ liegende UND-Gatter BI kann durch rasche Impulse durchgängig gemacht werden, so daß das Antwortsignal $\Phi_3$ getastet wird. Dann blinkt die Leuchtdiode LD im Rhythmus dieser z. B. durch den Zähltakt TM gegebenen und an den anderen Eingang des UND-Gatters BI gelegten Blinksignale. Bei Nichtvorhandensein des UND-Gatters BI leuchtet die Diode während der Dauer der Signale $\Phi_3$ stetig.

Mit jedem der Impulse $\Phi_2$ wird das jeweils am Anschluß A vorliegende Potential, also der Zustand der logischen »1« oder der Zustand der logischen »0« an das quasistatische Schieberegister gegeben. Ein Rückkippen des Flip-Flops $FF_1$ in den Ausgangszustand erfolgt aber erst, wenn der Ausgang des NOR-Gatters $N_1$ seinen logischen Zustand geändert hat, was erst mit dem Loslassen der Sensortaste möglich ist. Dieses Loslassen bedingt, daß mit dem folgenden Impuls $\Phi_2$ eine »1« an den Eingang des NOR-Gatters $N_1$ übertragen wird, so daß an dessen Ausgang eine »0« vorliegt. Wird dann der Sensorschalter SE erneut betätigt, so erscheint am Ausgang von $N_1$ die nächste »1« und damit der nächste Impuls, der zum Kippen von $FF_1$ in die Ausgangslage befähigt ist. Damit erlischt auch die Folge der Antwortsignale $\Phi_3$. Um den Zyklus erneut zu aktivieren, muß der Sensorschalter erneut, also das dritte Mal, betätigt werden.

Die in Fig. 1 dargestellte Schaltung verwendet eine quasistatische Schieberegisterzelle zwischen dem Anschluß A und der eigentlichen zu steuernden Digitalschaltung. Anstelle einer quasistatischen Schieberegisterzelle läßt sich auch eine Flip-Flop-Schieberegisterzelle verwenden. Eine geeignete Schaltung ist in Fig. 2 dargestellt.

Die Anwendung dieser Flip-Flop-Schieberegisterzelle gemäß Fig. 2 bedingt, daß nicht nur die zu der quasistatischen Schieberegisterzelle gehörenden Teile, nämlich die Teile $T_2$, $T_3$, $T_4$, $I_1$, $I_2$ und $N_1$, entfallen, sondern auch die Transistoren $T_7$ und $T_8$ durch einen in anderer Weise durch die beiden Flip-Flops $FF_1$ und $FF_2$ zu beaufschlagenden MOS-Feldeffekttransistor $T_9$ zu ersetzen sind. Im übrigen bleibt neben diesen beiden Flip-Flops auch der Dualzähler DZ erhalten. Auch die externen Schaltungsteile wie die eigentliche Digitalschaltung erfahren hierdurch keine Änderung.

Bei der in Fig. 2 zum Teil dargestellten Ausgestaltung einer Vorrichtung gemäß der Erfindung liegt der Anschluß A des Halbleiterkörpers an dem einen Eingang eines ersten UND-Gatters $U_1^*$ und außerdem über einen Inverter $I_4$ an dem einen Eingang eines zweiten UND-Gatters $U_2^*$. Die beiden anderen Eingänge dieser beiden UND-Gatter werden von den vom UND-Gatter $U_2$ des Dekoders in Fig. 1 gelieferten Impulsen $\Phi_2$ gesteuert. Dem durch die beiden UND-Gatter $U_1^*$ und $U_2^*$ gegebenen Eingangsteil (Master) ist ein durch die beiden kreuzgekoppelten NOR-Gatter $N_1^*$ und $N_2^*$ gegebenes NOR-Latch als weiterer Bestandteil einer ersten Flip-Flopzelle des Schieberegisters nachgeschaltet. Die Ausgänge dieser ersten Flip-Flopzelle dienen zur Steuerung einer zweiten gleichen Flip-Flopzelle, deren Eingangs-UND-Gatter $U_3^*$ und $U_4^*$ neben den besagten Ausgängen der ersten Flip-Flopzelle der Schieberegisterzelle durch ein Schiebetaktsignal TS gesteuert sind. Die Ausgänge der beiden UND-Gatter $U_3^*$ und $U_4^*$ steuern ein durch die beiden kreuzgekoppelten NOR-Gatter $N_3^*$ und $N_4^*$ gegebenes zweites NOR-Latch, dessen beide Ausgänge unmittelbar an je einen der nicht an den Ausgang von $FF_1$ gekoppelten Eingänge der beiden UND-Gatter $UN_1$ und $UN_2$ des Toggle-Flip-Flops $FF_1$ gelegt sind.

Der nicht invertierende Ausgang, also der Ausgang des NOR-Gatters $NO_1$ der Flip-Flopzelle $FF_1$ liegt am Sourceanschluß des bereits genannten MOS-Feldeffekttransistors $T_9$, dessen Drain mit dem Anschluß A verbunden ist. Zur Gatesteuerung des Transistors $T_9$ dient der Ausgang der Flip-Flopzelle $FF_2$ in einer zur Steuerung des Transistors $T_8$ bei einer Anlage gemäß Fig. 1 entsprechenden Weise.

Der Taktgeber TG kann gegenüber dem bei einer Anordnung gemäß Fig. 1 zu verwendenden Taktgeber TG vereinfacht werden, weil nur der Zähltakt für den Dualzähler DZ und der Takt TS zur Beaufschlagung der beiden UND-Gatter $U_3^*$ und $U_4^*$ im Eingangsteil der zweiten Flip-Flopzelle des Schieberegisters gemäß Fig. 2 benötigt wird. Zweckmäßig verwendet man einen Taktgeber, wie er in der DE-Patentanmeldung P 2 713 319.3 (VPA 77 P 1027) mit der Bezeichnung »Elektronischer Taktgeber für elektrische Digitalanlagen« am 25. 3. 1977 angemeldet wurde. Der von diesem Taktgeber gelieferte Takt TM dient wiederum zweckmäßig als Zähltakt für den Dualzähler DZ, während der Takt TS in der soeben angegebenen Weise verwendet wird.

Die Wirkungsweise der durch die Schaltungs-

teile gemäß Fig. 2 abgewandelten digitalen Halbleiterschaltung entspricht im wesentlichen der unveränderten Ausgestaltung gemäß Fig. 1. Zu Beginn des Betriebes der Anlage liegt am Anschluß A das der logischen »0« entsprechende Betriebspotential $V_{SS}$. Durch die erste Betätigung des Sensorschalters kommt an den Eingang der ersten Flip-Flopzelle des Flip-Flop-Schieberegisters ein Schaltimpuls, wodurch diese Flip-Flopzelle und beim folgenden Impuls TS auch die zweite Flip-Flopzelle des Schieberegisters und das Toggle-Flip-Flop $FF_1$ in den anderen Betriebszustand versetzt wird. Damit erhält der Transistor $T_9$ eine Source-Drainspannung. Durch die beiden Takte $\Phi_2$ und TS wird also eine Aktivierung des Transistors $T_9$ erreicht, der in diesem Zustand schließlich beim nächsten Kippen von $FF_2$ (bedingt durch den Dualzähler DZ und das UND-Gatter $U_3$) leitend wird, so daß es zum Aufleuchten der Leuchtdiode LD kommt.

Die Aktivierung der Leuchtdiode wird auch hier erst abgeschlossen, wenn der Sensorschalter SE das zweite Mal betätigt wird. Zur Reaktivierung ist eine dritte Betätigung der Sensortaste SE erforderlich, wie dies auch bei einer Anordnung gemäß Fig. 1 der Fall ist.

Die anhand der beiden Fig. 1 und 2 dargestellte bevorzugte Ausgestaltung einer Vorrichtung gemäß der Erfindung ist insbesondere für den Einsatz in einer elektronischen Orgel geeignet.

**Patentansprüche**

1. Monolithisch integrierte digitale MOS-Halbleiterschaltung mit einem als Signaleingang dienenden elektrischen Anschluß (A) an der Oberfläche des die Halbleiterschaltung aufnehmenden Halbleiterkörpers, bei der dieser Anschluß durch einen manuell zu bedienenden Sensorschalter (SE) mit einem aufgrund dieser Betätigung entstehenden und an die digitale Halbleiterschaltung weiterzuleitenden Sensorsignal zu beaufschlagen ist und aufgrund dieser Beaufschlagung in der digitalen Halbleiterschaltung ein Antwortsignal ($\Phi_3$) entsteht, welches unter Vermittlung des besagten elektrischen Anschlusses zur Beaufschlagung eines externen Indikators (LD) vorgesehen ist, bei der zur Erzeugung des Antwortsignals ($\Phi_3$) eine auf das Sensorsignal ansprechende Schaltung im Halbleiterkörper vorgesehen und derart ausgestaltet ist, daß der elektrische Anschluß (A) über einen getakteten Schaltungsteil an eine Flip-Flopzelle ($FF_1$) gelegt ist, bei der außerdem zwecks Erzeugung des Sensorsignals die dem elektrischen Anschluß (A) des Halbleiterkörpers abgewandte Seite des Sensorschalters (SE) an ein Versorgungspotential ($V_{GG}$) angeschlossen ist, welches zusammen mit einem Bezugspotential ($V_{ss}$) auch zur Versorgung der integrierten Halbleiterschaltung vorgesehen ist, dadurch gekennzeichnet, daß der elektrische Anschluß (A) des Halbleiterkörpers über die Source-Drainstrecke eines ersten MOS-Feldeffekttransistors ($T_1$) und über eine hierzu parallel geschaltete Kapazität (C) an das den logischen Pegel »0« bedeutende Bezugspotential ($V_{ss}$) gelegt und für die Steuerung des Gates des ersten Feldeffekttransistors ($T_1$) eine erste Folge periodischer Taktimpulse ($\Phi_1$) vorgesehen ist, daß durch die erste Folge periodischer Taktimpulse ($\Phi_1$) die in der Kapazität (C) gespeicherte Ladung abgebaut wird und der elektrische Anschluß (A) auf das Bezugspotential ($V_{ss}$) (mit logischem Pegel »0«) gezogen wird, so daß nach jeder Beaufschlagung über den Sensorschalter (SE) der elektrische Anschluß (A) auf die nächste Beaufschlagung vorbereitet wird, daß bei der nächsten Betätigung des Sensorschalters (SE) das Versorgungspotential ($V_{GG}$) an den elektrischen Anschluß (A) gelegt und damit eine Aufladung der Kapazität (C) eingeleitet wird, daß außerdem der elektrische Anschluß (A) zur Steuerung eines im übrigen noch von den Impulsen einer zweiten Taktfolge ($\Phi_2$) beaufschlagten Schaltungsteils mit UND-Funktion an den Informationseingang einer getakteten Schieberegisterzelle angeschaltet ist, deren Ausgang zur Beaufschlagung der — bereits der eigentlichen digitalen Halbleiterschaltung angehörenden — Flip-Flopzelle ($FF_1$) dient, daß ferner der elektrische Anschluß (A) über einen aus einem Feldeffekttransistor bestehenden Schaltungsteil mit dem Versorgungspotential ($V_{GG}$ mit logischem Pegel »1«) beaufschlagt und hierzu dieser Schaltungsteil sowohl durch einen Ausgang der Flip-Flopzelle ($FF_1$) als auch durch eine weitere Folge ($\Phi_4$) von Taktimpulsen gesteuert ist, und daß schließlich die in einer gemeinsamen Anlage erzeugten drei Folgen von Taktimpulsen ($\Phi_1$, $\Phi_2$, $\Phi_4$) derart aufeinander abgestimmt sind, daß kein Impuls mit einem Impuls einer anderen dieser Taktfolgen gleichzeitig erscheint und daß unmittelbar vor jedem Impuls der dritten Taktfolge ($\Phi_4$) ein Impuls der zweiten Taktfolge ($\Phi_2$) und unmittelbar vor dem Impuls der zweiten Taktfolge ($\Phi_2$) ein Impuls der ersten Taktfolge erscheint, wobei jede erneute Betätigung des Sensorschalters (SE) den Zustand der Flip-Flopzelle ($FF_1$) in den logisch entgegengesetzten Zustand bringt und ein dem Zustand der Flip-Flopzelle ($FF_1$) entsprechender und mit dem Impuls der dritten Taktfolge ($\Phi_4$) getaktetes Antwortsignal ($\Phi_3$) an den elektrischen Anschluß (A) gibt.

2. Halbleiterschaltung nach Anspruch 1, dadurch gekennzeichnet, daß der durch die Impulse der zweiten Taktfolge ($\Phi_2$) gesteuerte Schaltungsteil mit UND-Funktion durch einen MOS-Feldeffekttransistor ($T_2$) gegeben ist, dessen Gate durch die Taktimpulse ($\Phi_2$) beaufschlagt ist, daß außerdem die durch diesen Feldeffekttransistor ($T_2$) gesteuerte Schieberegisterzelle als quasistatische Schieberegisterzelle ausgebildet und hierzu der Drain des Feldeffekttransistors ($T_2$) einerseits über einen Inverter ($I_1$) und einem diesem nachgeschalteten und durch eine vierte Folge (TS) von Taktimpulsen gesteuerten Feldeffekttransistor ($T_3$) mit dem einen Eingang eines — über einen zweiten Eingang rücksetzba-

ren — NOR-Gatters ($N_1$) und andererseits über einen weiteren, durch eine fünfte Folge (TSS) von Taktimpulsen gesteuerten Feldeffekttransistor ($T_4$) mit dem den Ausgang der Schieberegisterzelle bildenden Ausgang des besagten NOR-Gatters ($N_1$) verbunden ist, und daß schließlich die Impulse der vierten Taktfolge (TS) und der fünften Taktfolge (TSS) derart aufeinander abgestimmt sind, daß die jeweils einander zugeordneten Einzelimpulse aus beiden Taktfolgen (TS, TSS) gleichzeitig enden, daß aber die Impulse der fünften Taktfolge (TSS) den Wirkungspegel im Vergleich zu dem jeweils zugeordneten Impuls der vierten Taktfolge (TS) mit geringer Verzögerung erreichen.

3. Halbleiterschaltung nach Anspruch 1, dadurch gekennzeichnet, daß der durch die Impulse der zweiten Taktfolge ($\Phi_2$) gesteuerte Schaltungsteil mit UND-Funktion durch ein UND-Gatter ($U_1^*$) gegeben ist, dessen einer Eingang am elektrischen Anschluß (A) liegt und dessen zweiter Eingang durch die Impulse ($\Phi_2$) der zweiten Taktfolge gesteuert ist, daß außerdem der elektrische Anschluß (A) über einen Inverter ($I_4$) an den einen Eingang eines zweiten und im übrigen ebenfalls durch die Impulse der zweiten Taktfolge ($\Phi_2$) gesteuerten UND-Gatters ($U_2^*$) gelegt ist, daß dabei der Ausgang des ersten UND-Gatters ($U_1^*$) zur Steuerung des Setzeingangs und der Ausgang des zweiten UND-Gatters zur Steuerung des Rücksetzeingangs eines — insbesondere durch zwei kreuzgekoppelte NOR-Gatter ($N_1^*$, $N_2^*$) gegebenen — RS-Flip-Flops vorgesehen ist, und daß schließlich das RS-Flip-Flop ($N_1^*$, $N_2^*$) zur Beaufschlagung einer durch eine vierte Taktfolge (TS) gesteuerten und als Flip-Flop ausgebildeten Schieberegisterzelle ($U_3^*$, $U_4^*$, $N_3^*$, $N_4^*$) dient.

4. Halbleiterschaltung nach Anspruch 3, dadurch gekennzeichnet, daß die beiden Eingänge der Schieberegisterzelle durch je ein UND-Gatter ($U_3^*$, $U_4^*$) gegeben sind, wobei der invertierende Ausgang des die Schieberegisterzelle beaufschlagenden RS-Flip-Flops des Schaltungsteils mit UND-Funktion an den einen Eingang des einen UND-Gatters ($U_3^*$) und der nicht-invertierende Ausgang dieses RS-Flip-Flops ($N_1^*$, $N_2^*$) an den einen Eingang des anderen UND-Gatters ($U_4^*$) gelegt ist, während die beiden UND-Gatter ($U_3^*$, $U_4^*$) im übrigen durch die Impulse des vierten Taktsignals (TS) gesteuert sind, und daß außerdem die beiden UND-Gatter ($U_3^*$, $U_4^*$) zur Steuerung eines weiteren, insbesondere durch zwei kreuzgekoppelte NOR-Gatter ($N_3^*$, $N_4^*$) gegebenen und je einen Ausgang der Schieberegisterzelle bildenden RS-Flip-Flops dienen.

5. Halbleiterschaltung nach einem der Ansprüche 1 bis 4, dadurch gekennzeichnet, daß die durch den Ausgang der Schieberegisterzelle beaufschlagte und der eigentlichen digitalen Halbleiterschaltung angehörende Flip-Flopzelle ($FF_1$) als Zweispeicher-Flip-Flop ausgebildet ist.

6. Halbleiterschaltung nach Anspruch 2 und 5, dadurch gekennzeichnet, daß der Ausgang der

quasistatischen Schieberegisterzelle ($N_1$) unmittelbar an den einen Eingang zweier UND-Gatter ($UN_1$, $UN_2$) gelegt ist, die den Eingangsteil der Flip-Flopzelle ($FF_1$) bilden und deren anderer Eingang einerseits kapazitiv an das Bezugspotential ($V_{ss}$) und andererseits über einen Feldeffekttransistor ($T_5$, $T_6$) an je einen der beiden Signalausgänge der Flip-Flopzelle ($FF_1$) angeschlossen ist, daß ferner der Ausgang der quasistatischen Schieberegisterzelle ($N_1$) über einen Inverter ($I_2$) an das Gate der soeben genannten beiden Feldeffekttransistoren ($T_5$, $T_6$) angeschlossen ist und daß schließlich der Ausgangsteil der Flip-Flopzelle ($FF_1$) durch ein — insbesondere durch zwei kreuzgekoppelte NOR-Gatter ($NO_1$, $NO_2$) gegebenes — RS-Flip-Flop realisiert ist.

7. Halbleiterschaltung nach einem der Ansprüche 1 bis 6, dadurch gekennzeichnet, daß der zur Beaufschlagung des elektrischen Anschlusses (A) mit dem Pegel logisch »1« vorgesehene und sowohl durch einen Ausgang der — bereits der eigentlichen digitalen Halbleiterschaltung angehörenden — Flip-Flopzelle ($FF_1$) als auch durch die dritte Impulsfolge ($\Phi_4$) gesteuerte Schaltungsteil durch die Reihenschaltung zweier Feldeffekttransistoren ($T_7$, $T_8$) gegeben ist, die eine Verbindung zwischen dem den Pegel logisch »1« bedeutenden Versorgungspotential ($V_{GG}$) und dem elektrischen Anschluß (A) bildet, und daß hierbei das Gate des einen Feldeffekttransistors ($T_7$) an den einen Signalausgang ($NO_1$) der Flip-Flopzelle ($FF_1$) und das Gate des anderen Feldeffekttransistors ($T_8$) an den die dritte Impulsfolge ($\Phi_4$) liefernden Schaltungsteil (BI, $NO_4$) angeschlossen ist.

8. Halbleiterschaltung nach einem der Ansprüche 1 bis 6, dadurch gekennzeichnet, daß der zur Beaufschlagung des elektrischen Anschlusses (A) mit dem Pegel logisch »1« vorgesehene und sowohl durch einen Ausgang der — bereits der eigentlichen digitalen Halbleiterschaltung angehörenden — Flip-Flopzelle ($FF_1$) als auch durch die dritte Impulsfolge ($\Phi_4$) gesteuerte Schaltungsteil durch einen einzigen Feldeffekttransistor ($T_9$) gegeben ist, dessen Gate durch die Impulse ($\Phi_4$) der dritten Taktfolge beaufschlagt ist und dessen Source-Drainstrecke einerseits an dem elektrischen Anschluß (A) und andererseits an dem besagten Ausgang ($NO_1$) der Flip-Flopzelle ($FF_1$) liegt.

9. Halbleiterschaltung nach einem der Ansprüche 1 bis 8, dadurch gekennzeichnet, daß der die erste Impulsfolge ($\Phi_1$) sowie die zweite Impulsfolge ($\Phi_2$) und die dritte Impulsfolge ($\Phi_4$) liefernde Schaltungsteil durch einen aus mehreren hintereinander geschalteten Zählstufen ($Z_1$—$Z_5$) bestehenden Dualzähler (DZ) gegeben ist, der seinerseits durch einen neben den Impulsen der vierten und der fünften Taktfolge (TS, TSS) eine sechste Taktfolge (TM) liefernden Taktgeber (TG) mittels der sechsten Taktfolge (TM) beaufschlagt ist und der über die Ausgänge seiner Zählstufen ($Z_1$—$Z_5$) mit einem Dekoder verbunden ist, der an einem ersten Ausgang ($U_1$) die erste Folge ($\Phi_1$) von Taktimpulsen, an einem

zweiten Ausgang ($U_2$) die zweite Folge ($\Phi_2$) von Taktimpulsen und an einem dritten Ausgang ($NO_4$ bzw. BL) die dritte Taktfolge ($\Phi_4$) zur Verfügung stellt.

10. Halbleiterschaltung nach Anspruch 9, dadurch gekennzeichnet, daß der Taktgeber (TG) in an sich bekannter Weise derart ausgebildet ist, daß die Impulse der sechsten Taktfolge (TM) jeweils in die Pause zwischen dem unmittelbar vorausgehenden und dem unmittelbar nachfolgenden Impuls der vierten Taktfolge (TS) fallen.

11. Halbleiterschaltung nach Anspruch 9 oder 10, dadurch gekennzeichnet, daß die Zählstufen ($Z_1 \ldots Z_5$) des Dualzählers (DZ) durch je eine der — bereits zur eigentlichen digitalen Halbleiterschaltung gehörenden — Flip-Flopzelle ($FF_1$) im Aufbau entsprechenden Flip-Flopzelle gegeben ist.

12. Halbleiterschaltung nach einem der Ansprüche 9 bis 11, dadurch gekennzeichnet, daß die sechste Taktfolge (TM) unmittelbar an den einen Eingang und über einen Inverter ($I_3$) an den anderen Eingang der ersten Zählstufe ($Z_1$) des Dualzählers (DZ) gelegt ist.

13. Halbleiterschaltung nach einem der Ansprüche 9 bis 12, dadurch gekennzeichnet, daß der Q-Ausgang der ersten Zählstufe (Q), der $\overline{Q}$-Ausgang der zweiten Zählstufe ($Z_2$) sowie der $\overline{Q}$-Ausgang der dritten Zählstufe ($Z_3$), der vierten Zählstufe ($Z_4$) und der fünften Zählstufe ($Z_5$) für die gemeinsame Steuerung eines an seinem Ausgang die Impulse der ersten Taktfolge ($\Phi_1$) liefernden und einen Bestandteil des Dekoders bildenden UND-Gatters ($U_1$) vorgesehen ist.

14. Halbleiterschaltung nach einem der Ansprüche 9 bis 13, dadurch gekennzeichnet, daß der $\overline{Q}$-Ausgang der ersten Zählstufe ($Z_1$) des Dualzählers (DZ) und der Q-Ausgang der zweiten Zählstufe ($Z_2$) sowie der $\overline{Q}$-Ausgang der dritten, der vierten und der fünften Zählstufe ($Z_3$, $Z_4$, $Z_5$) zur gemeinsamen Steuerung eines weiteren und an seinem Ausgang die Impulse der zweiten Taktfolge ($\Phi_2$) liefernden UND-Gatters ($U_2$) dienen.

15. Halbleiterschaltung nach einem der Ansprüche 9 bis 14, dadurch gekennzeichnet, daß der Q-Ausgang der dritten Zählstufe ($Z_3$) sowie der $\overline{Q}$-Ausgang der übrigen Zählstufen ($Z_1$, $Z_2$, $Z_4$, $Z_5$) zur gemeinsamen Steuerung der für die Erzeugung der dritten Folge ($\Phi_4$) von Taktimpulsen dienenden Anlage vorgesehen sind, daß diese Anlage aus einem ersten UND-Gatter ($U_3$) und einem zweiten UND-Gatter ($U_4$) sowie aus einem RS-Flip-Flop ($FF_2$) besteht, daß hierbei die beiden UND-Gatter ($U_3$, $U_4$) in gleicher Weise durch die Zählstufen ($Z_1$—$Z_5$) des Dualzählers (DZ) gemeinsam gesteuert sind, daß außerdem diese beiden UND-Gatter ($U_3$, $U_4$) zur Beaufschlagung je eines der beiden Eingänge des — insbesondere durch zwei kreuzgekoppelte NOR-Gatter ($NO_3$, $NO_4$) gegebenen — RS-Flip-Flops ($FF_2$) vorgesehen sind und daß schließlich die dritte Taktfolge ($\Phi_4$) an einem der beiden Ausgänge des RS-Flip-Flops zur Verfügung gestellt ist.

16. Halbleiterschaltung nach Anspruch 15, dadurch gekennzeichnet, daß für die Steuerung des den elektrischen Anschluß (A) an den Pegel logisch »1« legenden Schaltungsteils die dritte Folge ($\Phi_4$) von Taktimpulsen über ein — zugleich von der sechsten Folge (TM) von Taktimpulsen gesteuertes — UND-Gatter (BI) zur Verfügung gestellt ist.

17. Halbleiterschaltung nach einem der Ansprüche 1 bis 16, dadurch gekennzeichnet, daß die in der Schaltung vorgesehenen MOS-Feldeffekttransistoren bezüglich des Leitungstyps ihrer Source- und Drainzonen einander gleich und insbesondere vom Anreicherungstyp sind.

**Claims**

1. A monolithic integrated digital MOS semiconductor circuit with a signal input electric terminal (A) at the surface of the semiconductor body which accommodates the semiconductor circuit, which terminal is to be supplied with a sensor signal by a manually operable sensor circuit (SE) to be forwarded to the digital semiconductor circuit, and as a result forms a response signal ($\Phi_3$) which serves to feed an external indicator (LD) via the aforementioned electric terminal, wherein, for the generation of the response signal ($\Phi_3$), a circuit which responds to the sensor signal is provided in the semiconductor body designed such that the electric terminal (A) is connected via a pulsed circuit component to a flip-flop cell (FF1), wherein moreover, for the generation of the sensor signal, that side of the sensor circuit (SE) remote from the electric terminal (A) of the semiconductor body is connected to a supply potential ($V_{GG}$) which serves, together with a reference potential ($V_{ss}$), to supply the integrated semiconductor circuit, characterized in that the electrical terminal (A) of the semiconductor body is connected to the reference potential ($V_{ss}$) which signifies the logic level »0« via the source-drain path of a first MOS field effect transistor ($T_1$) and via a capacitor (C) connected in parallel therewith, and a first sequence of period clock pulses ($\Phi_1$) is provided for controlling the gate of the first field effect transistor ($T_1$), that the charge stored in the capacitor (C) is discharged by the first sequence of periodic clock pulses ($\Phi_1$) and the electric terminal (A) is brought to the reference potential ($V_{ss}$) (with logic level »0«), so that following each supply via the sensor switch (SE) the electric terminal (A) is prepared for the next supply, that when the sensor switch (SE) is next operated the supply potential ($V_{GG}$) is applied to the electric terminal (A) and thus the charging of the capacitor (C) is initiated, that moreover, for the control of a circuit component which possesses an AND function and is supplied with the pulses of a second pulse train ($\Phi_2$), the electric terminal (A) is connected to the information input of a pulsed shift register cell whose output serves to supply the flip-flop cell ($FF_1$) — which already belongs to the actual digital semiconductor circuit — that moreover the electric terminal (A) is supplied via a circuit component, composed of a field effect transistor, with the supply potential (V$_{GG}$ with logic level »1«) and for this purpose this circuit component is controlled both by an input of the flip-flop cell (FF$_1$) and by a further sequence ($\Phi_4$) of clock pulses, and that finally the three sequences of clock pulses ($\Phi_1$, $\Phi_2$, $\Phi_4$), generated in a common system, are matched to one another in such manner that no pulse appears simultaneously with a pulse of another of these clock pulse sequences, and that directly preceding each pulse of the third clock pulse sequence ($\Phi_4$) there appears a pulse of the second clock pulse sequence ($\Phi_2$), and directly preceding the pulse of the second clock pulse sequence ($\Phi_2$) there appears a pulse of the first clock pulse sequence, where each new operation of the sensor switch (SE) changes the status of the flip-flop cell (FF$_1$) into the opposite logic status, and causes a response signal ($\Phi_3$) which corresponds to the status of the flip-flop cell (FF$_1$) and is pulsed by the pulse of the third clock pulse sequence ($\Phi_4$) to be emitted to the electric terminal (A).

2. A semiconductor circuit as claimed in claim 1, characterized in that the circuit component which possesses an AND-function and is controlled by the pulses of the second clock pulse sequence ($\Phi_2$) consists of a MOS-field effect transistor (T$_2$) whose gate is supplied with the clock pulses ($\Phi_2$) , that moreover the shift register cell controlled by this field effect transistor (T$_2$) represents a quasi-static shift register cell and for this purpose the drain of the field effect transistor (T$_2$) is connected on the one hand via an inverter (I$_1$) and a following field effect transistor (T$_3$) controlled by a fourth sequence (TS) of clock pulses to the first input of a NOR-gate (N1) — which can be reset via a second input — and on the other hand is connected via a further field effect transistor (T$_4$) controlled by a fifth sequence (TSS) of clock pulses to that output of the aforementioned NOR-gate (N1) which forms the output of the shift register cell, and that finally the pulses of the fourth clock pulse sequence (TS) and of the fifth clock pulse sequence (TSS) are matched to one another in such manner that those individual pulses from the two clock pulse sequences (TS, TSS) which are assigned to one another end simultaneously, but that the pulses of the fifth clock pulse sequence (TSS) reach the active level with a slight delay in comparison to the relatid pulse of the fourth clock pulse sequence (TS).

3. A semiconductor circuit as claimed in claim 1, characterized in that the circuit component which possesses an AND-function and is controlled by the pulses of the second clock pulse sequence ($\Phi_2$) consists of an AND-gate (U$_1$*) whose first input is connected to the electric terminal (A) and whose second input is controlled by the pulses ($\Phi_2$) of the second clock pulse sequence, that moreover the electric terminal (A) is connected via an inverter (I$_4$) to the first input of a second AND-gate (U$_2$*) which

moreover is likewise controlled by the pulses of the second clock pulse sequence ($\Phi_2$), that the output of the first AND-gate (U$_1$*) serves to control the set input, whereas the output of the second AND-gate serves to control the reset input of an RS-type flip-flop — which consists in particular of two cross-coupled NOR-gates (N$_1$*, N$_2$*), and that finally the RS-type flip-flop (N$_1$*, N$_2$*) serves to supply a shift register cell (U$_3$*, U$_4$*, N$_3$*, N$_4$*) which is controlled by a fourth clock pulse sequence (TS) and consists of a flip-flop.

4. A semiconductor circuit as claimed in claim 3, characterized in that the two inputs of the shift register cell each consists of an AND-gate (U$_3$*, U$_4$*), where the inverting output of the RS-type flip-flop which supplies the shift register cell of the circuit component which possesses an AND-function is connected to the first input of the first AND-gate (U$_3$*), and the non-inverting output of this RS-type flip-flop (N$_1$*, N$_2$*) is connected to the first input of the other AND-gate (U$_4$*), whereas the two AND-gates (U$_3$*, U$_4$*) are controlled by the pulses of the fourth clock pulse signal (TS), and that moreover the two AND-gates (U$_3$*, U$_4$*) serve to control a further RS-type flip-flop which consists in particular of two cross-coupled NOR-gates (N$_3$*, N$_4$*) and in each case forms an output of the shift register cell.

5. A semiconductor circuit as claimed in one of claims 1 to 4, characterized in that the flip-flop cell (FF$_1$) connected to the output of the shift register cell and which forms part of the actual digital semiconductor circuit consists of a two-store flip-flop.

6. A semiconductor circuit as claimed in claims 2 and 5, characterized in that the output of the quasi-static shift register cell (N$_1$) is directly connected to the first input of two AND-gates (UN$_1$, UN$_2$) which form the input component of the flip-flop cell (FF$_1$) and whose other input is on the one hand capacitively connected to the reference potential (V$_{ss}$) and on the other hand is connected via a field effect transistor (T$_5$, T$_6$) to in each case one of the two signal outputs of the flip-flop cell (FF$_1$), that moreover the output of the quasistatic shift register cell (N$_1$) is connected via an inverter (I$_2$) to the gates of the two above-mentioned field effect transistors (T$_5$, T$_6$), and that finally the output component of the flip-flop cell (FF$_1$) consists of a RS-type flip-flop which is formed in particular by two cross-coupled NOR-gates (NO$_1$, NO$_2$).

7. A semiconductor circuit as claimed in one of claims 1 to 6, characterized in that the circuit component provided to supply the electric terminal (A) with the logic level »1« and is controlled both by an output of the flip-flop cell (FF$_1$) — which already forms part of the actual digital semiconductor circuit — and also by the third pulse sequence ($\Phi_4$), consists of the series arrangement of two field effect transistors (T$_7$, T$_8$) which forms a connection between the supply potential (V$_{GG}$), which signifies the logic level »1«, and the electric terminal (A), and that here the gate of the first field effect transistor ($T_7$) is connected to the first signal output ($NO_1$) of the flip-flop cell ($FF_1$) and the gate of the other field effect transistor ($T_8$) is connected to the circuit component (BI, $NO_4$) which supplies the third pulse sequence ($\Phi_4$).

8. A semiconductor circuit as claimed in one of claims 1 to 6, characterized in that the circuit component provided to supply the electric terminal (A) with the logic level »1« and which is controlled both by an output of the flip-flop cell ($FF_1$) — which already forms part of the actual digital semiconductor circuit — and also by the third pulse sequence ($\Phi_4$), consists of one single field effect transistor ($T_9$) whose gate is supplied with the pulses ($\Phi_4$) of the third clock pulse sequence and whose source-drain path is connected on the one hand to the electric terminal (A) and on the other hand to the aforementioned output ($NO_1$) of the flip-flop cell ($FF_1$).

9. A semiconductor circuit as claimed in one of claims 1 to 8, characterized in that the circuit component which supplies the first pulse sequence ($\Phi_1$), the second pulse sequence ($\Phi_2$) and the third pulse sequence ($\Phi_4$) consists of a dual counter (DZ) which consists of a plurality of counter stages ($Z_1 - Z_5$) connected in series, and which is itself supplied by means of a sixth clock pulse sequence (TM) by a clock pulse generator (TG) — which supplies the sixth clock pulse sequence (TM) in addition to the pulses of the fourth and fifth clock pulse sequences (TS, TSS) — and which is connected via the outputs of its counter stages ($Z_1 - Z_5$) to a decoder which makes available the first sequence ($\Phi_1$) of clock pulses at a first output ($U_1$), the second sequence ($\Phi_2$) of clock pulses at a second output ($U_2$), and the third clock pulse sequence ($\Phi_4$) at a third output ($NO_4$ and BL).

10. A semiconductor circuit as claimed in claim 9, characterized in that the clock pulse generator (TG) is designed in such known manner that the pulses of the sixth clock pulse sequence (TM) each fall in the pause between the directly preceding and the directly following pulse of the fourth clock pulse sequence (TS).

11. A semiconductor circuit as claimed in claim 9 or 10, characterized in that the counter stages ($Z_1 \ldots Z_5$) of the dual counter (DZ) each consist of a flip-flop cell corresponding in construction to the flip-flop cells ($FF_1$) — which already form part of the actual digital semiconductor circuit.

12. A semiconductor circuit as claimed in one of claims 9 to 11, characterized in that the sixth clock pulse sequence (TM) is applied directly to the first input and is applied via an inverter ($I_3$) to the other input of the first counter stage ($Z_1$) of the dual counter (DZ).

13. A semiconductor circuit as claimed in one of claims 9 to 12, characterized in that the Q-output of the first counter stage ($\overline{Q}$), the Q-output of the second counter stage ($Z_2$), and the $\overline{Q}$-output of the third counter stage ($Z_3$) of the fourth counter stage ($Z_4$) and of the fifth counter stage ($Z_5$) are provided for the common control of an AND-gate ($U_1$) which supplies at its output the pulses of the first clock pulse sequence ($\Phi_1$) and forms part of the decoder.

14. A semiconductor circuit as claimed in one of claims 9 to 13, characterized in that the $\overline{Q}$-output of the first counter stage ($Z_1$) of the dual counter (DZ) and the Q-output of the second counter stage ($Z_2$) and the $\overline{Q}$-output of the third, fourth and fifth counter stages ($Z_3$, $Z_4$, $Z_5$) serve to commonly control a further AND-gate ($U_2$) which supplies at its output the pulses of the second clock pulse sequence ($\Phi_2$).

15. A semiconductor circuit as claimed in one of claims 9 to 14, characterized in that the Q-output of the third counter stage ($Z_3$) and the $\overline{Q}$-output of the other counter stages ($Z_1$, $Z_2$, $Z_4$, $Z_5$) serve to commonly control the system which generates the third sequence ($\Phi_4$) of clock pulses, that this system consists of a first AND-gate ($U_3$), a second AND-gate ($U_4$) and an RS-type flip-flop ($FF_2$), that the two AND-gates ($U_3$, $U_4$) are commonly controlled in the same way by the counter stages ($Z_1 - Z_5$) of the dual counter (DZ), that these two AND-gates ($U_3$, $U_4$) each serve to supply one of the two inputs of the RS-type flip-flop ($FF_2$) — which consists in particular of two cross-coupled NOR-gates ($NO_3$, $NO_4$), and that finally the third clock pulse sequence ($\Phi_4$) is made available at one of the two outputs of the RS-type flip-flop.

16. A semiconductor circuit as claimed in claim 15, characterized in that for the control of the circuit component which connects the electric terminal (A) to the logic level »1« the third sequence ($\Phi_4$) of clock pulses is made available via an AND-gate (BI) — which is simultaneously controlled by the sixth sequence (TM) of clock pulses.

17. A semiconductor circuit as claimed in one of claims 1 to 16, characterized in that the MOS field effect transistors which are provided in the circuit are mutually identical in respect of the conductivity type of their source and drain zones and in particular are of the enhancement type.

**Revendications**

1. Circuit semiconducteur numérique monolithiquement intégré en technologie MOS, avec une borne électrique (A), servant d'entrée de signaux, sur la surface du corps semiconducteur recevant le circuit à semiconducteurs, dans lequel cette borne est à charger par un interrupteur à effleurement (SE) à commander manuellement, avec un signal d'effleurement qui se forme à la suite de cette commande et qui est à transmettre au circuit à semiconducteurs numérique, cette charge entraînant la formation, dans le circuit à semiconducteurs numérique, d'un signal de réponse ($\Phi_3$) qui est prévu, pour charger, par l'intermédiaire de ladite borne électrique, un indicateur extérieur (LD), dans lequel, pour la production du signal de réponse ($\Phi_3$) il est prévu dans le corps semiconducteur un circuit qui est sensible au signal d'effleurement et qui est réalisé de telle façon que la borne électrique (A) est reliée, par l'intermédiaire d'une partie de circuit cadencée, à une cellule flip-flop (FF1), dans lequel, en outre, et pour la production du signal d'effleurement, le côté du circuit à effleurement (SE) qui est éloigné de la borne électrique (A) du corps semiconducteur, est porté à un potentiel d'alimentation ($V_{GG}$) qui, avec un potentiel de référence ($V_{ss}$) est également prévu pour l'alimentation du circuit à semiconducteurs intégré, caractérisé par le fait que la borne électrique (A) du corps semiconducteur est portée, par l'intermédiaire du circuit source-drain d'un premier transistor à effet de champ MOS ($T_1$) et par l'intermédiaire d'une capacité (C) qui lui est montée en parallèle, au potentiel de référence ($V_{ss}$) qui correspond au niveau logique »0«, et qu'il est prévu, pour la commande de la grille du premier transistor à effet de champ ($T_1$), un premier train d'impulsions de cadence périodique ($\Phi_1$), que par le premier train d'impulsions de cadence périodique ($\Phi_1$), la charge emmagasinée dans la capacité (C) est détruite alors que la borne électrique (A) est amenée au potentiel de référence ($V_{ss}$) (à niveau logique »0«), de manière qu'après chaque charge par l'intermédiaire de l'interrupteur à effleurement (SE), la borne électrique (A) est préparée pour la prochaine charge, que lors de la commande suivante de l'interrupteur à effleurement (SE) le potentiel d'alimentation ($V_{GG}$) est appliqué à la borne électrique (A) et que de ce fait est introduite une charge de la capacité (C), qu'en outre, la borne électrique (A) est reliée, en vue de la commande d'une partie du circuit, à fonction ET, chargée en outre par des impulsions d'un second train de cadences ($\Phi_2$) à l'entrée d'informations d'une cellule de registre à décalage cadencée, dont la sortie sert à charger la cellule flip-flop (FF$_1$) — appartenant déjà au circuit à semiconducteurs numérique proprement dit —, qu'en outre la borne électrique (A) est portée, par l'intermédiaire d'une partie de circuit qui est constituée par un transistor à effet de champ, au potentiel d'alimentation ($V_{GG}$) avec niveau logique »1« et qu'à cet effet du circuit est commandée aussi bien par une sortie de la cellule flip-flop (FF$_1$) que par un autre train ($\Phi_4$) d'impulsions de cadence, et que finalement les trois trains d'impulsions de cadence ($\Phi_1$, $\Phi_2$, $\Phi_4$) qui sont produits dans une installation commune, sont adaptés les uns aux autres de telle manière qu'aucune impulsion n'apparaît simultanément avec une impulsion d'un autre de ces trains d'impulsions, et qu'immédiatement avant chaque impulsion du troisième train d'impulsions ($\Phi_4$) apparaît une impulsion du second train d'impulsions ($\Phi_2$) et immédiatement avant l'impulsion du second train d'impulsions ($\Phi_2$) apparaît une impulsion du premier train d'impulsions, la réalisation étant telle que chaque nouvelle commande de l'interrupteur à effleurement (SE) amène l'état de la cellule flip-flop (FF$_1$) dans l'état logique opposé et fournit à la borne électrique (A) un signal de réponse ($\Phi_3$) qui correspond à l'état de la cellule de flip-flop (FF$_1$) et cadencé avec l'impulsion du troisième train de cadences ($\Phi_4$).

2. Circuit à semiconducteurs selon la revendication 1, caractérisé par le fait que la partie du circuit à fonction ET, qui est commandé par les impulsions du second train de cadences ($\Phi_2$) est formée par un transistor à effet de champ MOS ($T_2$) dont la grille est chargée par les impulsions de cadence ($\Phi_2$), qu'en outre la cellule du registre à décalage, commandée par ce transistor à effet de champ ($T_2$) est réalisée sous la forme d'une cellule de registre à décalage quasi-statique, le drain du transistor à effet de champ ($T_2$) étant relié, d'une part par l'intermédiaire d'un inverseur ($I_1$) et d'un transistor à effet de champ ($T_3$) commandé par un quatrième train (TS) d'impulsions de cadence, à une entrée d'une porte NOR (N1) — susceptible d'être mis dans son état initial par l'intermédiaire d'une seconde entrée —, et, d'autre part, par l'intermédiaire d'un autre transistor à effet de champ ($T_4$) commandé par un cinquième train (TSS) d'impulsions de cadence, à la sortie de ladite porte NOR (N1) qui forme la sortie de la cellule du registre à décalage, et que finalement les impulsions du quatrième train d'impulsions (TS) et du cinquième train d'impulsions (TSS) sont adaptées l'une à l'autre de telle façon que les impulsions individuelles des deux trains de cadence (TS, TSS), qui sont respectivement associées entre elles, se terminent en même temps mais que les impulsions du cinquième train de cadence (TSS) atteignent le niveau d'efficacité avec un faible retard, comparativement à celui de l'impulsion associée du quatrième train de cadence (TS).

3. Circuit à semiconducteurs selon la revendication 1, caractérisé par le fait que la partie du circuit à fonction ET, qui est commandée par les impulsions du second train de cadences ($\Phi_2$), est formée par une porte ET (U$_1$*), dont une entrée est reliée à la borne électrique (A) et dont la seconde entrée est commandée par les impulsions ($\Phi_2$) du second train de cadence, qu'en outre, la borne électrique (A) est reliée, par l'intermédiaire d'un inverseur (I$_4$), à une entrée d'une seconde porte ET (U$_2$*) au demeurant commandée également par les impulsions du second train de cadences ($\Phi_2$), que ce faisant la sortie de la première porte ET (U$_1$*) est prévue pour la commande de l'entrée d'activation et la sortie de la seconde porte ET est prévue pour la commande de l'entrée de la remise à l'état initial d'un flip-flop-RS — formé, en particulier par deux portes NOR (N$_1$*, N$_2$*) à couplage en croix —, et que finalement le flip-flop-RS (N$_1$*, N$_2$*) sert à charger une cellule de registre à décalage (U$_3$*, U$_4$*, N$_3$*, N$_4$*) commandée par un quatrième train de cadences (TS) et réalisée comme un flip-flop.

4. Circuit à semiconducteurs selon la revendication 3, caractérisé par le fait que les deux entrées de la cellule de registre à décalage sont formées respectivement par une porte ET (U$_3$*, U$_1$*), la sortie inverseuse du flip-flop RS de la partie du circuit à fonction ET, qui charge la cellule du registre à décalage, est reliée à une entrée de la porte ET ($U_3^*$) alors que la sortie non inverseuse de ce flip-flop-RS ($N_1^*$, $N_2^*$) est reliée à l'entrée de l'autre porte ET ($U_4^*$), alors que les deux portes ET ($U_3^*$, $U_4^*$) sont, pour le reste commandées par les impulsions du quatrième signal de cadence (TS), et qu'en outre les deux portes ET ($U_3^*$, $U_4^*$) servent à commander un flip-flop RS supplémentaire, formé en particulier par deux portes NOR ($N_3^*$, $N_4^*$) à couplage croisé et formant chacun une sortie de la cellule de registre à décalage.

5. Circuit à semiconducteurs selon l'une des revendications 1 à 4, caractérisé par le fait que la cellule-flip-flop ($FF_1$) qui est chargée par la cellule de registre à décalage et qui appartient au circuit à semiconducteurs numérique proprement dit, est réalisée sous la forme d'un flip-flop à double mémoire.

6. Circuit à semiconducteurs selon la revendication 2 et 5, caractérisé par le fait que la sortie de la cellule de registre à décalage quasi-statique ($N_1$) est reliée directement à une entrée de deux portes ET ($UN_1$, $UN_2$), qui forment la partie d'entrée de la cellule-flip-flop ($FF_1$) et dont l'autre entrée est reliée d'une part capacitivement au potentiel de référence ($V_{ss}$) et d'autre part, par l'intermédiaire d'un transistor à effet de champ ($T_5$, $T_6$), à respectivement l'une des deux sorties de signaux de la cellule-flip-flop ($FF_1$), qu'en outre, la sortie de la cellule de registre à décalage ($N_1$) quasi-statique est reliée, par l'intermédiaire d'un inverseur ($I_2$), à la porte grille des deux transistors à effet de champ qui viennent d'être mentionnés, et que finalement la partie sortie de la cellule-flip-flop ($FF_1$) est réalisée par un flip-flop-RS, constitué en particulier par deux portes NOR ($NO_1$, $NO_2$) à couplage croisé.

7. Circuit à semiconducteurs selon l'une des revendications 1 à 6, caractérisé par le fait que la partie du circuit qui est prévue pour charger la borne électrique (A) avec le niveau logique »1« et qui est commandée aussi bien par une sortie de la cellule-flip-flop ($FF_1$) — qui appartient déjà au circuit à semiconducteurs numérique proprement dit — que par le troisième train d'impulsions ($\Phi_4$), est formée, par le circuit série de deux transistors à effet de champ ($T_7$, $T_8$), qui établit une liaison entre le potentiel d'alimentation ($V_{GG}$) équivalent au niveau logique »1« et la borne électrique (A), et que ce faisant, la grille de l'un ($T_7$) des transistors à effet de champ est relié à l'une des sorties des signaux ($NO_1$) de la cellule-flip-flop ($FF_1$) et la grille de l'autre transistor à effet de champ ($T_8$) est reliée à la partie du circuit (Bl, $NO_4$), qui fournit le troisième train d'impulsions ($\Phi_4$).

8. Circuit à semiconducteurs selon l'une des revendications 1 à 6, caractérisé par le fait que la partie du circuit qui est prévue pour charger la borne électrique (A) avec le niveau logique »1« et qui est commandée aussi bien par une sortie de la cellule-flip-flop ($FF_1$) — qui appartient déjà au circuit à semiconducteurs numérique proprement dit — que par le troisième train d'impulsions ($\Phi_4$) est formée par un transistor à effet de champ unique ($T_9$) dont la grille est chargée par les impulsions ($\Phi_4$) du troisième train de cadences et dont le circuit source-drain est relié d'une part à la borne électrique (A) et, d'autre part, à ladite sortie ($NO_1$) de la cellule-flip-flop ($FF_1$).

9. Circuit à semiconducteurs selon l'une des revendications 1 à 8, caractérisé par le fait que la partie du circuit qui fournit le premier train d'impulsions ($\Phi_1$) de même que le second train d'impulsions ($\Phi_2$) et le troisième train d'impulsions ($\Phi_4$) est constitué par un compteur binaire (DZ) formé par plusieurs étages de comptage ($Z_1 - Z_5$) montés à la suite l'un de l'autre, compteur binaire qui est à son tour chargé, par un générateur de cadences qui fournit en plus des impulsions du quatrième et du cinquième trains d'impulsions (TS, TSS), un sixième train de cadences (TM) avec le sixième train d'impulsions (TM), et qui est relié, par l'intermédiaire des sorties de ces étages de comptage ($Z_1 - Z_5$), à un décodeur qui fournit, à une première sortie ($U_1$) le premier train ($\Phi_1$) d'impulsions de cadence, à une seconde sortie ($U_2$) le second train ($\Phi_2$) d'impulsions de cadence et à une troisième sortie ($NO_4$ ou BL) le troisième train de cadences ($\Phi_4$).

10. Circuit à semiconducteurs selon la revendication 9, caractérisé par le fait que le générateur de cadences (TG) est réalisé, de façon connue en soi, de manière que les impulsions du sixième train de cadences (TM) se présentent respectivement dans l'intervalle situé entre l'impulsion directement précédente et l'impulsion directement suivante du quatrième train de cadences (TS).

11. Circuit à semiconducteurs selon la revendication 9 ou 10, caractérisé par le fait que les étages de comptage ($Z_1, \ldots Z_5$) du compteur bidirectionnel (DZ) sont chacun formés par une cellule-flip-flop dont la constitution correspond à la cellule-flip-flop ($FF_1$) appartenant déjà au circuit à semiconducteurs numérique proprement dit.

12. Circuit à semiconducteurs selon l'une des revendications 9 à 11, caractérisé par le fait que le sixième train de cadences (TM) est appliqué directement à une entrée et, par l'intermédiaire d'un inverseur ($I_3$) à l'autre entrée du premier étage de comptage ($Z_1$) du compteur bidirectionnel (DZ).

13. Circuit à semiconducteurs selon l'une des revendications 9 à 12, caractérisé par le fait que la sortie Q du premier étage de comptage (Q) la sortie $\overline{Q}$ du second étage de comptage ($Z_2$) de même que la sortie $\overline{Q}$ du troisième étage de comptage ($Z_3$) du quatrième étage de comptage ($Z_4$) et du cinquième étage de comptage ($Z_5$) sont prévues pour la commande commune d'une porte ET ($U_1$) fournissant, à sa sortie, les impulsions du premier train de cadences ($\Phi_1$) et constituant un élément constitutif du décodeur.

14. Circuit à semiconducteurs selon l'une des revendications 9 à 13, caractérisé par le fait que

la sortie $\overline{Q}$ du premier étage de comptage $(Z_1)$ du compteur binaire (DZ) et la sortie Q du second étage de comptage $(Z_2)$, de même que la sortie $\overline{Q}$ du troisième, du quatrième et du cinquième étages de comptage $(Z_3, Z_4, Z_5)$ servent à la commande commune d'une porte ET supplémentaire $(U_2)$ fournissant à sa sortie les impulsions du second train de cadences $(\Phi_2)$.

15. Circuit à semiconducteurs selon l'une des revendications 9 à 14, caractérisé par le fait que la sortie Q du troisième étage de comptage $(Z_3)$ de même que la sortie $\overline{Q}$ des autres étages de comptage $(Z_1, Z_2, Z_4, Z_5)$ sont prévues pour la commande commune de l'installation qui sert à produire le troisième train $(\Phi_4)$ d'impulsions de cadence, que cette installation est constituée par une première porte ET $(U_3)$ et par une seconde porte ET $(U_4)$ de même que par un flip-flop-RS $(FF_2)$, que ce faisant les deux portes ET $(U_3, U_4)$ sont commandées en commun et de la même façon par les étages de comptage $(Z_1, Z_5)$ du compteur binaire (DZ), qu'en outre les deux portes ET $(U_3, U_4)$ sont prévues pour charger respectivement l'une des deux sorties du flip-flop-RS $(FF_2)$ qui est formée en particulier par deux portes NOR $(NO_3, NO_4)$ à couplage croisé, et que finalement le troisième train de cadences $(\Phi_4)$ est mis à disposition au niveau de l'une des deux sorties du flip-flop-RS.

16. Circuit à semiconducteurs selon la revendication 15, caractérisé par le fait que pour la commande de la partie du circuit qui place la borne électrique (A) au niveau logique »1« le troisième train $(\Phi_4)$ d'impulsions de cadence est mis à disposition par l'intermédiaire d'une porte ET (BI) — commandée en même temps par le troisième train (TM) d'impulsions de cadence —.

17. Circuit à semiconducteurs selon l'une des revendications 1 à 7, caractérisé par le fait que les transistors à effet de champ MOS qui sont prévus dans le circuit sont, du point de vue du type de conductibilité de leurs zones de source et de drain, identiques entre eux, et, plus particulièrement, du type à enrichissement.

FIG 1

# FIG 2

# FIG 3